# EUROPÄISCHE PATENTSCHRIFT

(11) **EP 2 914 842 B1**
(45) Veröffentlichungstag und Bekanntmachung des Hinweises auf die Patenterteilung: **31.05.2017**
(21) Anmeldenummer: 13770905.1
(22) Anmeldetag: 30.09.2013
(51) Int. Cl.: F02M 63/00, F02M 51/06, H01F 7/08, H01L 41/053, H01F 7/16, H01L 41/06, H01L 41/12, H02N 2/02

(54) **AKTOR**
ACTUATOR
ACTIONNEUR

(30) Priorität: 31.10.2012 DE 102012219974
(43) Veröffentlichungstag der Anmeldung: 09.09.2015
(73) Patentinhaber: Robert Bosch GmbH, 70442 Stuttgart (DE)
(72) Erfinder: PAUER, Thomas, 71691 Freiberg (DE); RETTICH, Andreas, 71083 Herrenberg-Kuppingen (DE); RICCO, Mario, I-70010 Casamassima (IT); BEIER, Marco, 70469 Stuttgart-Feuerbach (DE)
(86) Internationale Anmeldenummer: PCT/EP2013/070327
(87) Internationale Veröffentlichungsnummer: WO 2014/067729

(56) Entgegenhaltungen:
- EP-A2- 2 000 661
- DE-A1- 10 317 149
- US-A- 5 645 226

## Beschreibung

Die Erfindung betrifft einen Aktor, aufweisend ein Gehäuse, eine Spule, einen mit einem Stößel und einer Feder zusammenwirkenden Anker, dessen Ankerplatte gegenüberliegend zu einem Ankergegenstück angeordnet ist, und wobei der Aktor zumindest ein magnetostriktiv wirkendes Bauteil aufweist. Weiterhin betrifft die Erfindung ein Verfahren zum Betreiben eines derartigen Aktors.

### Stand der Technik

Ein derartiger Aktor ist aus der DE 198 43 534 A1 bekannt. Dieser Aktor ist an einem Kraftstoffinjektor für eine Brennkraftmaschine verbaut. Dabei ist der magnetostriktive Aktor seitlich an dem Kraftstoffinjektor angeschraubt und überträgt über ein Hydraulikfluid eine von dem Aktor ausgeführte Bewegung auf die Ventilnadel des Kraftstoffinjektors. Dazu ist zusätzlich zwischen dem Aktor und dem die Hydraulikflüssigkeit aufnehmenden Raum ein Übersetzerkolben angeordnet. Insgesamt ist der so ausgebildete Aktor mit dem Kraftstoffeinspritzventil bauaufwendig ausgebildet, wobei darüber hinaus der mögliche Bewegungsweg der Ventilnadel gering ist.

Aus der EP 2 000 661 A2 ist ein Kraftstoffeinspritzventil mit einem elektromagnetischen Aktor und einem magnetostriktiven Aktor bekannt.

Der Erfindung liegt die Aufgabe zugrunde, einen Aktor und ein Verfahren zum Betreiben eines Aktors anzugeben, mit denen große Stellwege bei hohen Stellkräften realisierbar sind.

### Offenbarung der Erfindung

### Vorteile der Erfindung

Diese Aufgabe wird dadurch gelöst, dass der Aktor zusätzlich als Hubmagnet ausgebildet ist und sich der magnetostriktive Aktor und der Hubmagnet einen Magnetkreis teilen. Das erfindungsgemäße Verfahren zeichnet sich dadurch aus, dass bei einer Bestromung der Spule sich ein magnetischer Fluss über den Aktor, den Stößel, ein Gleitstück und das Gehäuse bildet, durch den der magnetostriktiv ausgebildete Stößel ausgedehnt wird und nach dem Erreichen einer Grenzausdehnung die Anziehungskraft zwischen der Ankerplatte und dem Ankergegenstück ausreichend groß ist, um dem Anker mitsamt dem Stößel und dem Gleitstück zur Anlage an dem Ankergegenstück zu bewegen. Dabei wirkt der Aktor zusätzlich als Hubmagnet. Der besondere Vorteil der Erfindung liegt also in der Kombination eines magnetostriktiven Aktors beziehungsweise magnetostriktiv wirkenden Aktors mit einem Hubmagneten, wobei sich beide Aktorkonzepte einen Magnetkreis teilen. Dadurch werden mehrere Vorteile erreicht. Es wird nur eine Spule benötigt, wodurch der Bauraumbedarf für den Aktor insgesamt gering ist. Die Anzahl der Bauteile ist ebenfalls gering. Der magnetostriktive Aktor muss nur einen geringen Stellweg zurücklegen, so dass dieser insgesamt klein ausgebildet sein kann. Schließlich kann der Kraftverlauf der so ausgebildeten Aktorkombination besser auf entsprechende Anforderungen angepasst werden. Zusammenfassend wird somit ein Aktor bereitgestellt, der bei übersichtlichem Aufbau und geringen Kosten in der Lage ist, große Stellwege bei hohen Stellkräften zu realisieren.

In Weiterbildung der Erfindung ist der Stößel magnetostriktiv ausgebildet. Magnetostriktion ist die Deformation magnetischer (insbesondere ferromagnetischer) Stoffe in Folge eines angelegten magnetischen Feldes. Dabei erfährt der Körper, vorliegend der Stößel, bei konstantem Volumen eine elastische Längenänderung. Geeignete Werkstoffe für den Stößel sind Werkstoffe mit einer hohen Magnetostriktion, beispielsweise Terfenol oder Eisen-Nickel-Legierungen.

In weiterer Ausgestaltung der Erfindung ist der Stößel zwischen dem Anker und auf der gegenüberliegenden Seite einem Gleitstück angeordnet. Bei einer Bestromung der Spule dehnt sich der Stößel aus und verschiebt den Anker letztendlich bis zu einem Grenzausdehnungsbetrag gegenüber dem gehäusefest sich abstützenden Gleitstück.

In Weiterbildung der Erfindung sind der Anker und das Gleitstück mittels einer den Stößel umfassenden Feder miteinander verbunden. Durch die Feder wird die notwendige Vorspannung auf den Stößel aufgebracht. Dabei ist in weiterer Ausgestaltung die Feder als Hülsenfeder ausgebildet, die zudem eine Zugfeder ist. Die Hülsenfeder ist fest mit dem Anker und dem Gleitstück verbunden und spannt den Stößel zwischen den genannten Bauteilen mit einer definierten Kraft ein.

In Weiterbildung der Erfindung ist das Gleitstück zylinderförmig ausgebildet und in einer Ausnehmung in dem Gehäuse geführt. Einerseits wird dadurch eine Führung des Verbundes, bestehend aus dem Gleitstück, dem Stößel, dem Anker und der Hülsenfeder realisiert und andererseits wird durch die Führung ein verlustarmer magnetischer Fluss gewährleistet.

In Weiterbildung der Erfindung ist die Spule zumindest den Stößel und die Feder umfassend in dem Gehäuse angeordnet. Dabei kann die Spule weiterhin auch noch einen Teilbereich jeweils des Ankers und des Gleitstücks umfassen, um auch bei den vorgesehenen Bewegungen der Bauteile eine möglichst konstante Kraft auf die Bauteile auszuüben.

In Weiterbildung der Erfindung wirkt der Anker gegenüberliegend zu dem Stößel mit einer Kopplerstange zusammen. Dabei ist die Kopplerstange bevorzugt mit der Ankerplatte verbunden und durch eine Öffnung in dem Ankergegenstück hindurchgeführt. Dabei wird mit der Kopplerstange die entsprechende Bewegung auf zu bewegende Bauteile übertragen und darüber hinaus eine Führung der bewegbaren Bauteile auf der gegenüberliegenden Seite zu dem Gleitstück erreicht. Das zu betätigende Bauteil ist in Weiterbildung der Erfindung ein Kraftstoffinjektor eines Einspritzsystems für eine Brennkraftmaschine. Dabei ist der so ausgebildete Aktor vorteilhaft in das Gehäuse eines solchen Kraftstoffinjektors zu integrieren.

Weitere vorteilhafte Ausgestaltungen der Erfindung sind der Zeichnungsbeschreibung zu entnehmen, in der ein in der Zeichnung dargestelltes Ausführungsbeispiel der Erfindung näher beschrieben ist.

### Kurze Beschreibung der Zeichnungen

Es zeigen:
- Figur 1: in einem Kraft-Weg-Diagramm verschiedene Kraftverläufe von Aktoren und einem Kraftverlauf, der für eine Bewegung einer Ventilnadel notwendig ist und
- Figur 2: einen erfindungsgemäß ausgebildeten Aktor, der an einem Kraftstoffeinspritzventil verbaut ist.

### Ausführungsform der Erfindung

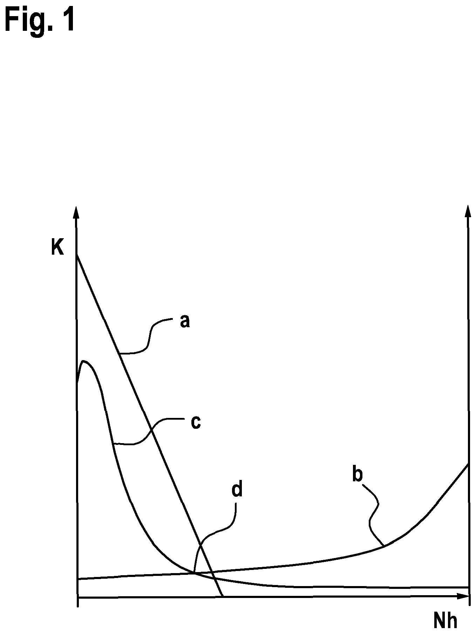

Figur 1 zeigt ein Kraft-Weg-Diagramm mit verschieden Kraftverläufen beziehungsweise Hubverläufen von unterschiedlichen Aktoren und einem typischen hydraulischen Kraftverlauf, der auf eine Ventilnadel eines Kraftstoffinjektors ausgeübt werden muss, um diese zu bewegen.

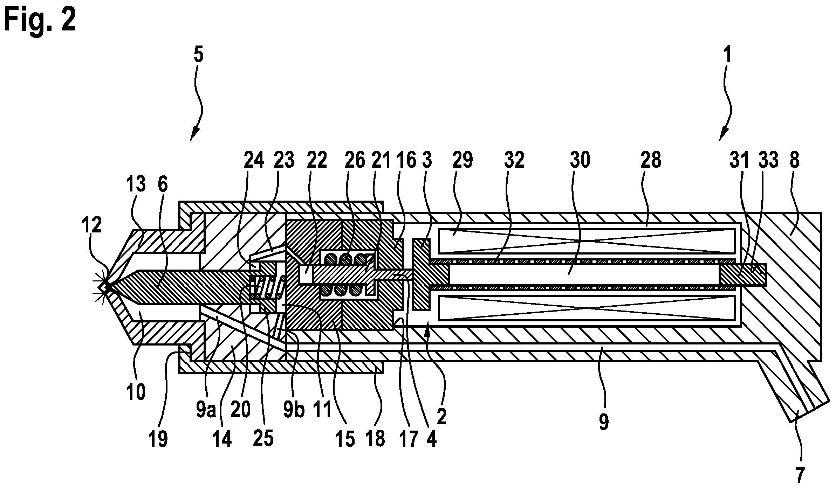

Dabei ist auf der Abszisse ist der Nadelhub Nh (oder Stellweg) einer Ventilnadel, der einem zu überwindenden Luftspalt in einem (Magnet)-Aktor entspricht, und auf der Ordinate die Kraft K aufgetragen. Die Kennlinie a gibt den typischen Kraftverlauf eines magnetostriktiven Aktors wieder, der ausgehend von einer hohen Anfangskraft und einer dann linear abnehmenden Kraft nur einen geringen Gesamtstellweg ausführt. Die Kennlinie b gibt den typischen Kraftverlauf eines magnetischen Hubaktors (Hubmagnets) wieder, der ausgehend von einer geringen Anfangskraft eine zunehmende Krafterhöhung bei einem großen Gesamtstellweg aufweist. Die Kennlinie c kennzeichnet einem typischen hydraulischen Kraftverlauf, der auf in Figur 2 dargestellte Ventilnadel 6 eines Kraftstoffinjektors 5 ausgeübt werden muss, um diese zu bewegen. Bei einer Kombination der beiden Aktoren mit den Kennlinien a und b ergibt sich ein Wechselpunkt d von einem magnetostriktiven Aktor auf einen Hubmagneten an dem Schnittpunkt der Kennlinien c und b. Weiterhin ist ersichtlich, dass durch die erfindungsgemäße Kombination eines magnetostriktiven Aktors und eines Hubmagnets immer eine Kraft erzeugt wird, die deutlich höher ist, als die Kraft, die für eine Bewegung der Ventilnadel 6 notwendig ist.

Der in Figur 2 dargestellte Aktor 1 ist in dem dargestellten Ausführungsbeispiel mit einem Kraftstoffinjektor 5 verschaltet, kann aber grundsätzlich auch mit beliebigen anderen Einrichtungen oder Komponenten, bei denen ein zugehöriges Bauteil bewegt werden sollen, verbunden sein. Der Kraftstoffinjektor 5 ist Teil eines Common-Rail-Einspritzsystems, mit dem Kraftstoff, insbesondere Dieselkraftstoff unter hohem Druck in einen zugeordneten Brennraum einer vorzugsweise selbstzündenden Brennkraftmaschine eingespritzt werden soll.

Dazu wird dem Kraftstoffinjektor 5 über eine Hochdruckleitung, die mit einem Hochdruckleitungsanschluss 7 an einem gemeinsamen Gehäuse 8 des Aktors 1 und des Kraftstoffinjektors 5 angeordnet ist, zugeführt. Der Hochdruckleitungsanschluss 7 ist über Verbindungskanäle 9, 9a, 9b mit einem Ventilnadelraum 10 und einem Steuerraum 11 verbunden. In der dargestellten Position der Ventilnadel 6 sind Einspritzöffnungen 12, durch die in dem Ventilnadelraum 10 befindlicher Kraftstoff in den Brennraum eingespritzt werden kann, von einer Ventilnadelspitze der Ventilnadel 6 verschlossen. Die Einspritzöffnungen 12 sind in einem Ventilnadelkörper 13 angeordnet, der mit einem Ventilkörper 14 zusammenwirkt. Der Ventilkörper 14 wirkt seinerseits mit einem Zwischenstück 15 zusammen, das an ein Ankergegenstück 16 angrenzt. Das Zwischenstück 15 und das Ankergegenstück 16 sind in das Gehäuse 8 eingeführt und das Ankergegenstück 16 stützt sich auf einem Absatz 17 in dem Gehäuse 8 ab. Die genannten Bauteile werden von einer Überwurfmutter 18 miteinander verspannt, wobei die Überwurfmutter 18 sich mit einem Ringabsatz 19 an dem Ventilnadelkörper 13 abstützt und mit dem gegenüberliegenden Endbereich auf das Gehäuse 8 aufgeschraubt ist.

Die Ventilnadel 6 wird von einer Ventilnadelfeder 20, die im Bereich des Steuerraums 11 angeordnet ist und sich an der Ventilnadel 6 und dem Zwischenstück 1 abstützt, in die die Einspritzöffnungen 12 verschließende Position gedrückt. Gleichzeitig wird von dem in dem Steuerraum 11 und dem Ventilnadelraum 10 herrschenden Kraftstoffhochdruck unterstützt durch einen Stufenabsatz 25 an der Ventilnadel 6 eine zusätzliche Schließkraft zu der von der Ventilnadelfeder 20 auf die Ventilnadel 6 ausgeübt.

Geöffnet werden die von der Ventilnadel 6 beherrschten Einspritzöffnungen 12, wenn die Ventilnadel 6 in Richtung zu dem Zwischenstück 15 bewegt wird. Eine solche Bewegung wird ausgeführt, wenn eine durch eine Öffnung in dem Ankergegenstück 16 hindurchgeführte Kopplerstange 22 von dem Aktor 1 in Richtung zu dem Steuerraum 11 bewegt wird und in einem Aktorraum 22 befindliches Fluid, insbesondere Kraftstoff, durch eine Verbindung 23 in einen Ventilnadelsteuerraum 24 gefördert wird. Der Ventilnadelsteuerraum 24 ist dem Steuerraum 11 gegenüberliegend an dem Stufenabsatz 25 der Ventilnadel 6 angeordnet und bei genügend hohem Druck in dem Ventilnadelsteuerraum 24 wird die Ventilnadel 6 entgegen der Kraft der Ventilnadelfeder 20 und dem in dem Steuerraum 11 herrschenden Kraftstoffdruck in Richtung zu dem Zwischenstück 15 gedrückt. Beendet wird die so eingeleitete Einspritzung, indem der Fluiddruck in dem Ventilnadelsteuerraum 24 abgesenkt wird und die von der Ventilnadelfeder 20 und dem Kraftstoffdruck in dem Steuerraum 11 ausgeübte Kraft größer wird als die in dem Ventilnadelsteuerraum 24 und dem Ventilnadelraum 10 herrschenden Kräfte. Dieser Zustand wird durch eine entsprechende Ansteuerung beziehungsweise Abschaltung des Aktors 1 bewirkt.

Die Kopplerstange 21 wird von einer Kopplerstangenfeder 26 gegen die Ankerplatte 3 gedrückt und kann beispielsweise in einer Ausnehmung in der Ankerplatte 3 zur Lagefixierung der Ankerplatte 3 geführt sein.

Der Aktor 1 weist einen in das Gehäuse 8 eingelassenen Raum 28 auf, der die Bauteile des Aktors 1 aufnimmt. Insbesondere ist in dem Raum 28 eine Spule 29 angeordnet und in geeigneter Weise befestigt. Die Spule 29 ist über Anschlussleitungen mit einer Spannungsquelle schaltbar verbunden. Innerhalb der Spule 29 ist ein aus einem magnetostriktiven Material hergestellter Stößel 30 zwischen dem Anker 2 und einem gegenüberliegenden Gleitstück 31 angeordnet. Der Anker 2 ist mit dem Gleitstück 31 unter Einschluss des Stößels 30 mit einer Hülsenfeder 32 verbunden, die eine benötigte Vorspannung auf den Stößel 30 ausübt. Das Gleitstück 31 ist in einer Ausnehmung 33 in dem Gehäuse 8 beweglich geführt. Dieses Führung des Gleitstücks 31 in der Ausnehmung 33 bewirkt bei einer Bestromung der Spule 29 einen zumindest verlustarmen magnetischen Kreis bestehend aus dem Ankergegenstück 16, dem Anker 2, dem magnetostriktiven Stößel 30, dem Gleitstück 31 und dem Gehäuse 8. Gleichzeitig bewirkt die Führung des Gleitstücks 31 in der Ausnehmung 33 eine Führung des Stößels 30 mitsamt dem Anker 2.

Wird die Spule 29 bestromt, bildet sich zunächst ein magnetischer Fluss über den Stößel 30, den Anker 2, das Gehäuse 8 und das Gleitstück 31. Dieser Fluss erzeugt eine Anziehungskraft zwischen dem Anker 2 und dem Ankergegenstück 16, die jedoch nicht groß genug ist, um letztendlich die Ventilnadel 6 aus dem Sitz zur Freigabe der Einspritzöffnungen 12 zu heben. Durch das erzeugte magnetische Feld will sich der magnetostriktive Stößel 30 ausdehnen. Durch die Kraft, welche auf die Ventilnadel 6 über den Ventilnadelsteuerraum 24 und den Aktorsteuerraum 22 und der Kopplerstange 21 auf den Anker 2 wirkt, wird diese Ausdehnung behindert. Dies führt zu einer Druckkraft in dem magnetostriktiven Stößel 30. Der Stößel 30 wird sich so weit ausdehnen, bis ein Gleichgewicht zwischen der Druckkraft in dem Stößel 30 und der Kraft an der Kopplerstange 21 eingestellt ist. Hierdurch kommt es zu einer Volumenreduzierung im Aktorsteuerraum 22, wobei das verdrängte Fluid durch die Verbindung 23 in den Ventilnadelsteuerraum 24 gedrückt wird. Hierdurch wird die Ventilnadel 6 aus dem Sitz gehoben. Wenn die Ventilnadel 6 einen ausreichenden Hub vollzogen hat, ist die Anziehungskraft zwischen dem Anker 2 und dem Ankergegenstück 16 ausreichend groß, um die Bauteile Anker 2, Stößel 30, Gleitstück 31 und Hülsenfeder 32 zu bewegen. In diesem Zustand wirkt der Aktor 1 (zusätzlich) als Hubmagnet. Diese Bewegung wird durch den Aktorsteuerraum 22 und den Ventilnadelsteuerraum 24 in eine weitere Bewegung der Ventilnadel 6 umgesetzt. Über die Flächenverhältnisse in dem Aktorsteuerraum 22 und dem Ventilnadelsteuerraum 24 kann eine Kraftuntersetzung beziehungsweise Kraftübersetzung realisiert werden. Beendet wird die so eingeleitete Einspritzung dadurch, dass die Spule 29 stromlos geschaltet wird, und demzufolge der Anker 2 mitsamt dem Stößel 30 und dem Gleitstück 31 wieder in die dargestellte Ausgangslage bewegt werden. Dadurch wird der Druck in dem Ventilnadelsteuerraum 24 reduziert und die Ventilnadel 6 wird wieder in die die Einspritzöffnungen 12 verschließende Position bewegt.

## Patentansprüche

1. Aktor (1), aufweisend ein Gehäuse (8), eine Spule (29), einen mit einem Stößel (30) und einer Feder zusammenwirkenden Anker (2), dessen Ankerplatte (3) gegenüberliegend zu einem Ankergegenstück (16) angeordnet ist, und wobei der Aktor (1) zumindest ein magnetostriktiv wirkendes Bauteil aufweist, wobei der Aktor (1) zusätzlich als Hubmagnet ausgebildet ist, **dadurch gekennzeichnet, dass** sich der magnetostriktive Aktor und der Hubmagnet einen Magnetkreis teilen.

2. Aktor (1) nach Anspruch 1,
**dadurch gekennzeichnet, dass** der Stößel (30) magnetostriktiv ausgebildet ist.

3. Aktor (1) nach einem der vorherigen Ansprüche,
**dadurch gekennzeichnet, dass** der Stößel (30) zwischen dem Anker (2) und auf der gegenüberliegenden Seite einem Gleitstück (31) angeordnet ist.

4. Aktor (1) nach Anspruch 3,
**dadurch gekennzeichnet, dass** der Anker (2) und das Gleitstück (31) mittels einer den Stößel (30) umfassenden Feder miteinander verbunden sind.

5. Aktor (1) nach Anspruch 4,
**dadurch gekennzeichnet, dass** die Feder eine Hülsenfeder (32) ist.

6. Aktor (1) nach Anspruch 4 oder 5,
**dadurch gekennzeichnet, dass** die Feder eine eine Vorspannung auf den Stößel (30) ausübende Zugfeder ist.

7. Aktor (1) nach einem der Ansprüche 3 bis 6,
**dadurch gekennzeichnet, dass** das Gleitstück (31) zylinderförmig ausgebildet und in einer Ausnehmung (33) in dem Gehäuse (8) geführt ist.

8. Aktor (1) nach einem der vorherigen Ansprüche,
**dadurch gekennzeichnet, dass** die Spule (29) zumindest den Stößel (30) und die Feder umfassend in dem Gehäuse (8) angeordnet ist.

9. Aktor (1) nach einem der vorherigen Ansprüche,
**dadurch gekennzeichnet, dass** der Anker (2) gegenüberliegend zu dem Stößel (30) mit einer Kopplerstange (21) zusammenwirkt.

10. Aktor (1) nach Anspruch 9,
**dadurch gekennzeichnet, dass** die Kopplerstange (21) durch eine Öffnung in dem Ankergegenstück (16) hindurchgeführt ist.

11. Kraftstoffinjektor (5) mit einem Aktor (1) nach einer der vorherigen Ansprüche.

12. Verfahren zum Betreiben eines Aktors mit den Merkmalen des Anspruchs 1, **dadurch gekennzeichnet, dass** bei einer Bestromung der Spule (29) sich ein magnetischer Fluss über den Anker (2), den Stößel (30), ein Gleitstück (31) und das Gehäuse (8) bildet, durch den der magnetostriktiv ausgebildete Stößel (30) ausgedehnt wird und dass nach dem Erreichen einer Grenzausdehnung die Anziehungskraft zwischen der Ankerplatte (3) und dem Ankergegenstück (16) ausreichend groß ist, um den Anker (2) mitsamt dem Stößel (30) und dem Gleitstück (31) hubmagnetartig zur Anlage an dem Ankergegenstück (16) zu bewegen.

## Claims

1. Actuator (1), having a housing (8), a coil (29), an armature (2) which interacts with a tappet (30) and a spring, and of which the armature plate (3) is arranged opposite an armature counterpiece (16), and wherein the actuator (1) has at least one magnetostrictively acting component, wherein the actuator (1) is additionally designed as a solenoid,
**characterized in that** the magnetostrictive actuator and the solenoid share a magnetic circuit.

2. Actuator (1) according to Claim 1,
**characterized in that** the tappet (30) is of magnetostrictive design.

3. Actuator (1) according to either of the preceding claims,
**characterized in that** the tappet (30) is arranged between the armature (2) and, on the opposite side, a sliding piece (31).

4. Actuator (1) according to Claim 3,
**characterized in that** the armature (2) and the sliding piece (31) are connected to one another by means of a spring which surrounds the tappet (30).

5. Actuator (1) according to Claim 4,
**characterized in that** the spring is a sleeve spring (32).

6. Actuator (1) according to Claim 4 or 5,
**characterized in that** the spring is a tension spring which exerts a pretension onto the tappet (30).

7. Actuator (1) according to one of Claims 3 to 6,
**characterized in that** the sliding piece (31) is of cylindrical design and is guided in a recess (33) in the housing (8).

8. Actuator (1) according to one of the preceding claims,
**characterized in that** the coil (29) is arranged in the housing (8) so as to surround at least the tappet (30) and the spring.

9. Actuator (1) according to one of the preceding claims,
**characterized in that** the armature (2) interacts with a coupler rod (21) opposite the tappet (30).

10. Actuator (1) according to Claim 9,
**characterized in that** the coupler rod (21) is guided through an opening in the armature counterpiece (16).

11. Fuel injector (5) comprising an actuator (1) according to one of the preceding claims.

12. Method for operating an actuator having the features of Claim 1,
**characterized in that**, when current is applied to the coil (29), a magnetic flux forms across the armature (2), the tappet (30), a sliding piece (31) and the housing (8), the magnetostrictive tappet (30) being extended by said magnetic flux, and **in that**, after a limit extension is reached, the attraction force between the armature plate (3) and the armature counterpiece (16) is large enough to move the armature (2), together with the tappet (30) and the sliding piece (31), to bear against the armature counterpiece (16) in the manner of a solenoid.

## Revendications

1. Actionneur (1), comportant un boîtier (8), une bobine (29), un induit (2) coopérant avec un poussoir (30) et un ressort, dont la plaque d'induit (3) est disposée en position opposée à une pièce complémentaire d'induit (16), et dans lequel l'actionneur (1) comporte au moins un composant à effet magnétostrictif, dans lequel l'actionneur (1) est en outre réalisé sous la forme d'un aimant de levage,
**caractérisé en ce que** l'actionneur magnétostrictif et l'aimant de levage se partagent un circuit magnétique.

2. Actionneur (1) selon la revendication 1,
**caractérisé en ce que** le poussoir (30) est réalisé de manière magnétostrictive.

3. Actionneur (1) selon l'une quelconque des revendications précédentes,
**caractérisé en ce que** le poussoir (30) est disposé entre l'induit (2) et une pièce coulissante (31) située du côté opposé.

4. Actionneur (1) selon la revendication 3,
**caractérisé en ce que** l'induit (2) et la pièce coulissante (31) sont reliés l'un à l'autre au moyen d'un ressort comprenant le poussoir (30).

5. Actionneur (1) selon la revendication 4, **caractérisé en ce que** le ressort est un ressort de manchon (32).

6. Actionneur (1) selon la revendication 4 ou 5,
**caractérisé en ce que** le ressort est un ressort de traction exerçant une précontrainte sur le poussoir (30).

7. Actionneur (1) selon l'une quelconque des revendications 3 à 6,
**caractérisé en ce que** la pièce coulissante (31) est réalisée de manière à présenter une forme cylindrique et **en ce qu'**elle est guidée dans un évidement (33) ménagé dans le boîtier (8).

8. Actionneur (1) selon l'une quelconque des revendications précédentes,
**caractérisé en ce que** la bobine (29) est disposée dans le boîtier (8) de manière à entourer au moins le poussoir (30) et le ressort.

9. Actionneur (1) selon l'une quelconque des revendications précédentes,
**caractérisé en ce que** l'induit (2) coopère avec une tige de couplage (21) en s'opposant au poussoir (30).

10. Actionneur (1) selon la revendication 9,
**caractérisé en ce que** la tige de couplage (21) est introduite à travers une ouverture ménagée dans la pièce complémentaire d'induit (16).

11. Injecteur de carburant (5) comportant un actionneur (1) selon l'une quelconque des revendications précédentes.

12. Procédé de mise en fonctionnement d'un actionneur présentant les caractéristiques de la revendication 1, **caractérisé en ce que**, lors de l'alimentation en courant de la bobine (29), il se forme un flux magnétique passant par l'intermédiaire de l'induit (2), du poussoir (30), d'une pièce coulissante (31) et du boîtier (8), à travers lequel s'étend le poussoir (30) formé de manière magnétostrictive, et **en ce que**, après qu'une extension limite a été atteinte, la force d'attraction entre la plaque d'induit (3) et la pièce complémentaire d'induit (16) est suffisamment élevée pour déplacer l'induit (2) ainsi que le poussoir (30) et la pièce coulissante (31) à la façon d'un aimant de levage afin qu'ils viennent en contact avec la pièce complémentaire d'induit (16).
